# EUROPÄISCHE PATENTSCHRIFT

(11) **EP 0 643 475 B1**
(45) Veröffentlichungstag und Bekanntmachung des Hinweises auf die Patenterteilung: **10.10.2007**
(21) Anmeldenummer: 94106035.2
(22) Anmeldetag: 19.04.1994
(51) Int. Cl.: H03D 1/22

(54) **Amplitudendemodulator**
Amplitude demodulator
Démodulateur d'amplitude

(30) Priorität: 11.09.1993 DE 4330891
(43) Veröffentlichungstag der Anmeldung: 15.03.1995
(73) Patentinhaber: Robert Bosch GmbH, 70442 Stuttgart (DE)
(72) Erfinder: Chahabadi, Djahanyar, Dr.-Ing., 23909 Ratzeburg (DE); Vogt, Lothar, Dr., D-31249 Hohenhameln (DE)

(56) Entgegenhaltungen:
- DE-A- 3 938 643
- FR-A- 2 633 128

## Beschreibung

Die Erfindung betrifft einen Amplitudendemodulator für Rundfunkempfänger.

Aufgabe der vorliegenden Erfindung ist es, einen Amplitudendemodulator für Ründfunkempfänger anzugeben, welche weitgehend in digitaler Technik ausgeführt sind, so daß ein ebenfalls digital realisierter Amplitudendemodulator von den im Rundfunkempfänger vorhandenen Taktsignalen Gebrauch machen kann (siehe auch z.B. das Dokument FR 2 633 128 A).

Der erfindungsgemäße Amplitudendemodulator umfasst Mittel zum Umwandeln eines Zwischenfrequenzsignals in ein digitales Zwischenfrequenzsignal, Mittel zum Umsetzen und Amplitudendemodulieren des digitalen Zwischenfrequenzsignals in das Basisband und Mittel zur geregelten Verstärkung des amplitudendemodulierten Signals im Sinne einer Konstanthaltung des Gleichanteils des amplitudendemodulierten Signals.

Ein wesentlicher Vorteil des erfindungsgemäßen Amplitudendemodulators besteht darin, daß durch eine digitale Schaltung in einem vorgegebenen Pegelbereich der Einfluß von Feldstärkeschwankungen kompensiert wird.

Gemäß einer vorteilhaften Ausgestaltung der Erfindung ist vorgesehen, daß zur Regelung der Verstärkung das amplitudendemodulierte Signal über einen Multiplizierer geleitet wird, daß vom Ausgangssignal des Multiplizierers mittels eines Tiefpasses der Gleichanteil abgetrennt wird und daß aus dem abgetrennten Gleichanteil eine Stellgröße abgeleitet wird, die dem Multiplizierer zugeführt wird. Dabei kann die Stellgröße aus dem Gleichanteil nach einem Gradientenverfahren abgeleitet werden.

Eine Kompensation des ebenfalls durch Feldstärkeschwankungen bedingten schwankenden Gleichanteils ist bei dem erfindungsgemäßen Amplitudendemodulator dadurch möglich, daß der abgetrennte Gleichanteil vom Ausgangssignal des Multiplizierers subtrahiert wird und daß das Ergebnis der Subtraktion einem Ausgang des Amplitudendemodulators zuführbar ist.

Außerdem kann bei dem erfindungsgemäßen Amplitudendemodulator vorgesehen sein, daß dem Gleichspannungsanteil vor Bildung der Stellgröße additiv und multiplikativ Einstellgrößen zuführbar sind.

Eine Weiterbildung des erfindungsgemäßen Amplitudendemodulator besteht darin, daß zur Bildung der Stellgröße der Gleichanteil über einen weiteren Multiplizierer und einen weiteren Subtrahierer geleitet wird, dessen Ausgangssignal über eine Verzögerungseinrichtung dem weiteren Multiplizierer und dem weiteren Subtrahierer zugeführt wird und nach einer Amplitudenbegrenzung die Stellgröße bildet

Bei der Ableitung der Stellgröße zur Verstärkungsregelung ist zu verhindern, daß NF-Nutzinformation außer dem Gleichanteil wirksam ist. Dazu ist ein Tiefpaß mit sehr geringer Grenzfrequenz erforderlich, was gemäß einer anderen Weiterbildung der Erfindung mit verhältnismäßig geringem Aufwand dadurch ermöglicht wird, daß der zur Ableitung des Gleichanteils dienende Tiefpaß aus einem ersten Tiefpaß, einer Dezimationsstufe und einem zweiten Tiefpaß besteht.

Um eine Multiplikation der Stellgröße mit dem amplitudendemodulierten Signal zu realisieren, ist vorgesehen, daß die Abtastfrequenz der Stellgröße vor der Zuführung zum Multiplizierer heraufgesetzt wird.

Eine günstige Auslegung der Anordnung zur Durchführung des Gradientenverfahrens besteht darin, daß die Verzögerungseinrichtung eine Verzögerung von einer Abtastperiode des Gleichanteils aufweist.

Die Umsetzung in das Basisband einschließlich der Amplitudendemodulation kann bei dem erfindungsgemäßen Amplitudendemodulator in vorteilhafter Weise dadurch erfolgen, daß durch Zuführung entsprechend phasenverschobener Referenzträger das Mischsignal in Form von zwei Quadraturkomponenten entsteht, das anschließend tiefpaßgefiltert wird. Dabei kann es zweckmäßig sein, die Tiefpaßfilterung in mehrere Stufen aufzuteilen, zwischen denen jeweils die Abtastfrequenz dezimiert wird, um den jeweils nachfolgenden Tiefpaß mit geringerem Aufwand realisieren zu können. Nach der Herabsetzung ins Basisband kann ein CORDIC-Algorithmus zur Erzeugung von Betrag und Phase aus den Quadraturkomponenten des in das Basisband herabgesetzten Mischsignals angewendet werden. Der Betrag stellt dann das dem Multiplizierer zugeführte amplitudendemodulierte Signal dar.

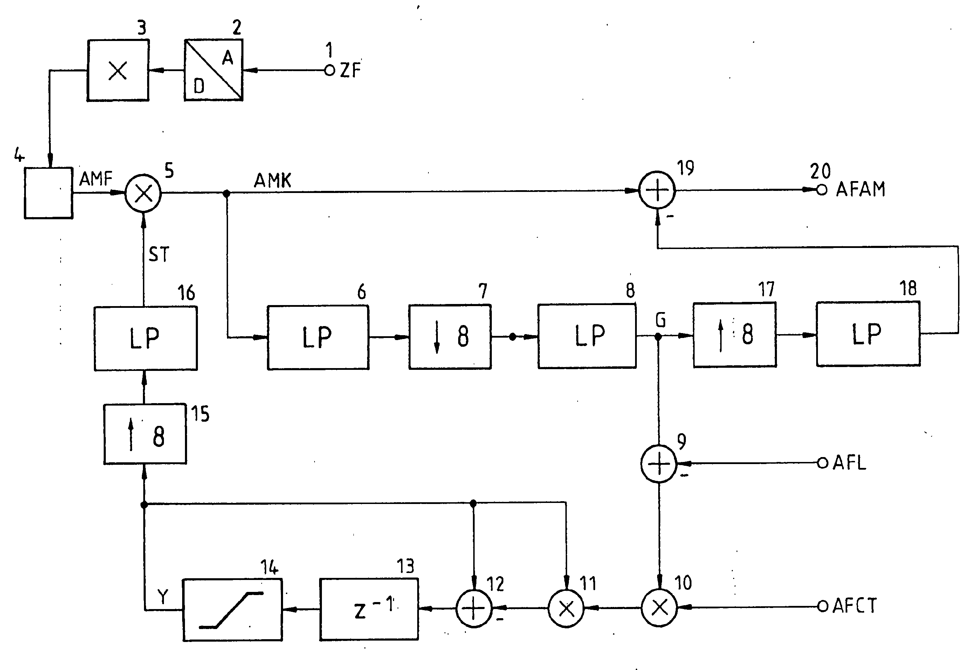

Ein Ausführungsbeispiel der Erfindung ist in der Zeichnung dargestellt und in der nachfolgenden Beschreibung näher erläutert.

Das Ausführungsbeispiel sowie Teile davon sind zwar als Blockschaltbilder dargestellt. Dieses bedeutet jedoch nicht, daß die erfindungsgemäße Schaltungsanordnung auf eine Realisierung mit Hilfe von einzelnen den Blöcken entsprechenden Schaltungen beschränkt ist. Die erfindungsgemäße Schaltungsanordnung ist vielmehr in besonders vorteilhafter Weise mit Hilfe von hochintegrierten Schaltungen realisierbar. Dabei kann beispielsweise ein digitaler Signalprozessor eingesetzt werden, welcher bei geeigneter Programmierung die im Blockschaltbild dargestellten Verarbeitungsschritte durchführt. Die erfindungsgemäße Schaltungsanordnung kann zusammen mit weiteren Schaltungsanordnungen innerhalb einer integrierten Schaltung wesentliche Teile eines Rundfunkempfängers bilden.

Dem erfindungsgemäßen Amplitudendemodulator wird bei 1 ein Zwischenfrequenzsignal zugeführt, das in einem Analog/Digital-Wandler 2 mit einer Frequenz von 14,25 MHz abgetastet und in ein digitales Zwischenfrequenzsignal umgewandelt wird. In einem anschließenden Mischer 3 wird dieses Signal ins Basisband gemischt und demoduliert. Dabei kann es zweckmäßig sein, die ursprüngliche Abtastrate von 14,25 MHz auf ein für die weitere Verarbeitung des Niederfrequenzsignals erforderliche Abtastfrequenz herabzusetzen, beispielsweise auf 45,6 kHz. Das Ausgangssignal des Amplitudendemodulators beinhaltet außer der NF-Nutzinformation noch einen Gleichanteil, der durch den ins Basisband gemischten AM-Träger entstanden ist. Hiervon ist auch die Amplitude des Ausgangssignals AMF des Demodulators abhängig. Zur Kompensation dieser Abhängigkeit ist ein Multiplizierer 5 vorgesehen, der das Signal AMF mit einer Stellgröße ST multipliziert. Diese Stellgröße wird, wie im folgenden beschrieben, aus dem Gleichanteil des Signals AMF gewonnen.

Zur Ableitung des Gleichanteils wird das Ausgangssignal des Multiplizierers 5 tiefpaßgefiltert. Da die Tiefpaßfilterung des Gleichanteils schmalbandig sein soll, so daß die Regelung nicht auf niederfrequente Anteile des NF-Signals anspricht, ist eine niedrige Grenzfrequenz erforderlich. Dazu wird das Ausgangssignal AMK des Multiplizierers 5 bei 6 ein erstes Mal tiefpaßgefiltert, dann bezüglich der Abtastrate bei 7 um den Faktor acht dezimiert und schließlich bei 8 ein zweites Mal tiefpaßgefiltert. Der am Ausgang des Tiefpaßfilters 8 anstehende Gleichanteil G ist zunächst einer Pegel- und Zeitkonstanteneinstellung für die Regelung unterworfen. Dazu sind ein Subtrahierer 9 und ein Multiplizierer 10 vorgesehen, denen Einstellgrößen AFL und AFCT für den Pegel und die Zeitkonstante der Regelung zuführbar sind.

Der somit beeinflußte Gleichanteil wird mit Hilfe eines Gradientenverfahrens in die Stellgröße ST umgewandelt. Dazu wird der Gleichanteil über einen weiteren Multiplizierer 11 und einen weiteren Subtrahierer 12 zu einer Verzögerungseinrichtung 13 um eine Abtastperiode des Gleichanteils G geleitet. An die Verzögerungseinrichtung 13 schließt sich ein Begrenzer 14 an, dessen Ausgangssignal y beidseitig begrenzt ist. Aufgabe des Begrenzers ist es, den Pegelbereich festzulegen, der ausgeregelt werden soll. Der Begrenzer 14 kann auch vor der Verzögerungseinrichtung angeordnet sein. Als Stellgröße kann dann auch das unverzögerte begrenzte Signal verwendet werden.

Das Ausgangssignal y des Begrenzers wird dann bei 15 und 16 zur Heraufsetzung der Abtastrate interpoliert und tiefpaßgefiltert und als Stellgröße ST dem Multiplizierer 5 zugeführt.

Um aus dem Signal AMK den Gleichanteil zu entfernen, wird der Gleichanteil G nach einer Interpolation bei 17 und einer Tiefpaßfilterung bei 18 einem Subtrahierer 19 zugeführt, an dessem Ausgang 20 das demodulierte NF-Signal AFAM entnehmbar ist.

## Patentansprüche

1. Amplitudendemodulator für Rundfunkempfänger umfassend
Mittel (2) zum Umwandeln eines Zwischenfrequenzsignals in ein digitales Zwischenfrequenzsignal,
Mittel (3, 4) zum Umsetzen und Amplitudendemodulieren des digitalen Zwischenfrequenzsignals in das Basisband und
Mittel (5-16) zur geregelten Verstärkung des amplitudendemodulierten Signals im Sinne einer Konstanthaltung des Gleichanteils des amplitudendemodulierten Signals.

2. Amplitudendemodulator nach Anspruch 1, **dadurch gekennzeichnet, daß** zur Regelung der Verstärkung das amplitudendemodulierte Signal über einen Multiplizierer (5) geleitet wird, daß vom Ausgangssignal des Multiplizierers (5) mittels eines Tiefpasses (6, 7, 8) der Gleichanteil abgetrennt wird und daß aus.dem abgetrennten Gleichanteil eine Stellgröße abgeleitet wird, die dem Multiplizierer (5) zugeführt wird.

3. Amplitudendemodulator nach Anspruch 2, **dadurch gekennzeichnet, daß** die Stellgröße aus dem Gleichanteil nach einem Gradientenverfahren abgeleitet wird.

4. Amplitudendemodulator nach einem der Ansprüche 2 oder 3, **dadurch gekennzeichnet, daß** der abgetrennte Gleichanteil vom Ausgangssignal des Multiplizierers (5) subtrahiert wird und daß das Ergebnis der Subtraktion einem Ausgang des Amplitudendemodulators zuführbar ist.

5. Amplitudendemodulator nach einem der Ansprüche 2 bis 4, **dadurch gekennzeichnet, daß** dem Gleichspannungsanteil vor Bildung der Stellgröße additiv und multiplikativ Einstellgrößen zuführbar sind.

6. Amplitudendemodulator nach einem der Ansprüche 3 bis 5, **dadurch gekennzeichnet, daß** zur Bildung der Stellgröße der Gleichanteil über einen weiteren Multiplizierer (11) und einen weiteren Subtrahierer (12) geleitet wird, dessen Ausgangssignal über eine Verzögerungseinrichtung (13) dem weiteren Multiplizierer (11) und dem weiteren Subtrahierer (12) zugeführt wird und nach einer Amplitudenbegrenzung (14) die Stellgröße bildet.

7. Amplitudendemodulator nach einem der vorhergehenden Ansprüche, **dadurch gekennzeichnet, daß** der zur Ableitung des Gleichanteils dienende Tiefpaß aus einem ersten Tiefpaß (6), einer Dezimationsstufe (7) und einem zweiten Tiefpaß (8) besteht.

8. Amplitudendemodulator nach Anspruch 7, **dadurch gekennzeichnet, daß** die Abtastfrequenz der Stellgröße vor der Zuführung zum Multiplizierer (5) heraufgesetzt wird.

9. Amplitudendemodulator nach einem der Ansprüche 6 oder 7, **dadurch gekennzeichnet, daß** die Verzögerungseinrichtung (13) eine Verzögerung von einer Abtastperiode des Gleichanteils aufweist.

## Claims

1. Amplitude demodulator for a broadcast radio receiver, comprising:
means (2) for conversion of an intermediate-frequency signal to a digital intermediate-frequency signal,
means (3, 4) for conversion and amplitude demodulation of the digital intermediate-frequency signal to baseband, and
means (5-16) for controlled amplification of the amplitude-demodulated signal in the sense of stabilization of the DC component of the amplitude-demodulated signal.

2. Amplitude demodulator according to Claim 1, **characterized in that** the amplitude-demodulated signal is passed via a multiplier (5) in order to control the gain, **in that** the DC component is cut off from the output signal from the multiplier (5) by means of a low-pass filter (6, 7, 8), and **in that** a manipulated variable is derived from the cut-off DC component and is supplied to the multiplier (5).

3. Amplitude demodulator according to Claim 2, **characterized in that** the manipulated variable is derived from the DC component using a gradient method.

4. Amplitude demodulator according to one of Claims 2 or 3, **characterized in that** the cut-off DC component is subtracted from the output signal from the multiplier (5), and **in that** the result of the subtraction can be supplied to one output of the amplitude demodulator.

5. Amplitude demodulator according to one of Claims 2 to 4, **characterized in that** setting variables can be supplied additively by multiplication to the DC voltage component, before the formation of the manipulated variable.

6. Amplitude demodulator according to one of Claims 3 to 5, **characterized in that** the manipulated variable is formed by passing the DC component via a further multiplier (11) and a further subtractor (12), whose output signal is supplied via a delay device (13) to the further multiplier (11) and to the further subtractor (12), and forms the manipulated variable, after amplitude limiting (14).

7. Amplitude demodulator according to one of the preceding claims, **characterized in that** the low-pass filter which is used to derive the DC component comprises a first low-pass filter (6), a decimation stage (7) and a second low-pass filter (8).

8. Amplitude demodulator according to Claim 7, **characterized in that** the sampling frequency of the manipulated variable is increased before being supplied to the multiplier (5).

9. Amplitude demodulator according to one of Claims 6 or 7, **characterized in that** the delay device (13) has a delay of one sample period of the DC component.

## Revendications

1. Modulateur d'amplitude pour récepteur radiophonique comprenant :
- des moyens (2) pour convertir un signal de fréquence intermédiaire en un signal numérique de fréquence intermédiaire,
- des moyens (3, 4) pour convertir et moduler en amplitude le signal de fréquence intermédiaire,
- des moyens (5-16) pour amplifier de manière régulée le signal modulé en amplitude dans le sens d'un maintien constant de la partie continue du signal modulé en amplitude.

2. Modulateur d'amplitude selon la revendication 1,
**caractérisé en ce que**
pour réguler l'amplification du signal modulé en amplitude, on fait passer celui-ci par un multiplicateur (5) et à la sortie du multiplicateur (5) on sépare la partie continue à l'aide d'un filtre passe-bas (6, 7, 8) et on déduit une grandeur de régulation à partir du signal continu, séparé, grandeur qui est fournie au multiplicateur (5).

3. Modulateur d'amplitude selon la revendication 2,
**caractérisé en ce qu'**
on déduit la grandeur de régulation de la partie continue après un procédé d'application d'un gradient.

4. Modulateur d'amplitude selon l'une des revendications 2 ou 3,
**caractérisé en ce qu'**
on retranche la partie continue séparée, par rapport au signal de sortie du multiplicateur (5) et
on applique le résultat de la soustraction à la sortie du démodulateur d'amplitude.

5. Modulateur d'amplitude selon l'une des revendications 2 à 4,
**caractérisé en ce qu'**
avant de former la grandeur de régulation, on applique les grandeurs de réglage par addition et par multiplication.

6. Modulateur d'amplitude selon l'une des revendications 3 à 5,
**caractérisé en ce que**
pour former la grandeur de régulation on applique la partie continue à un autre multiplicateur (11) et à un autre soustracteur (12) dont le signal de sortie est appliqué par l'intermédiaire d'un élément de temporisation (13) à l'autre multiplicateur (11) et à l'autre soustracteur (12) puis après une limitation d'amplitude (14) on forme la grandeur de régulation.

7. Modulateur d'amplitude selon l'une des revendications précédentes,
**caractérisé en ce que**
le filtre passe-bas servant à obtenir la partie continue se compose d'un premier filtre passe-bas (6), d'un étage de décimation (7) et d'un second filtre passe-bas (8).

8. Modulateur d'amplitude selon la revendication 7,
**caractérisé en ce que**
la fréquence de détection de la grandeur de régulation est relevée avant d'être appliquée au multiplicateur (5).

9. Modulateur d'amplitude selon l'une des revendications 6 ou 7,
**caractérisé en ce que**
l'élément de temporisation (13) assure une temporisation d'une période de détection de la partie continue.
